(19) Europäisches Patentamt
European Patent Office
Office européen des brevets

(11) EP 2 745 130 B1

(12) EUROPEAN PATENT SPECIFICATION

(45) Date of publication and mention
of the grant of the patent:
**04.07.2018 Bulletin 2018/27**

(51) Int Cl.:
**G01R 33/3415** [(2006.01)] **G01R 33/3873** [(2006.01)]

(21) Application number: **12761767.8**

(22) Date of filing: **07.08.2012**

(86) International application number:
**PCT/GB2012/051911**

(87) International publication number:
**WO 2013/024257 (21.02.2013 Gazette 2013/08)**

(54) **HYBRID MAGNET FOR MRI**

HYBRIDMAGNET FÜR DIE BILDGEBENDE MAGNETISCHE RESONANZ

AIMANT HYBRIDE POUR L'IRM

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.08.2011 GB 201114045**

(43) Date of publication of application:
**25.06.2014 Bulletin 2014/26**

(73) Proprietor: **Emscan Limited**
**Kent ME18 5TD (GB)**

(72) Inventors:
• **MCGINLEY, John Vincent Mario**
**London W5 3AL (GB)**
• **RISTIC, Mihailo**
**London NW11 7SN (GB)**

• **BESANT, Colin Bowden**
**Marlow, Buckinghamshire SL7 2QT (GB)**
• **YOUNG, Ian Robert**
**Marlborough, Wiltshire SN8 1HZ (GB)**

(74) Representative: **Prock, Thomas et al**
**Marks & Clerk LLP**
**90 Long Acre**
**London WC2E 9RA (GB)**

(56) References cited:
EP-A2- 0 760 484      EP-A2- 0 982 598
EP-A2- 0 982 599      EP-B1- 1 224 484
WO-A1-2009/013478      JP-A- 4 054 938
JP-A- 2000 333 932      US-A- 4 672 346
US-A- 5 194 810      US-A- 5 431 165
US-A- 5 677 630      US-B1- 6 861 933

**Description**

Field of the Invention

The present invention relates to a hybrid magnet for use in a magnetic resonance imaging (MRI) machine.

Background of the Invention

Our International Patent Application published as WO-A-2009/013478 discloses a magnet assembly for an MRI machine in which opposing poles are supported on a generally C-shaped yoke and a main field magnet coil, preferably of superconducting type is located at both poles, or only one, pole respectively. A counterbalancing member is provided to counterbalance the potentially destructive attractive force between pole(s) and yoke during operation. However, it is quite difficult to engineer this, or any other conventional structure, in a manner to ensure good field homogeneity in the imaging area between the poles.

Conventionally, in the construction of MRI machines, small field adjustments to fine-tune individual machines are effected using shims in the vicinity of the pole piece(s). These are typically discrete ferromagnetic or permanent magnet members. They are frequently employed in (optionally segmented) concentric rose ring' arrangements, such as described in the aforementioned WO-A-2009/013478 or in US-A-5 431 165, US-A-5 194 810 and US-A-6 335 670. A combination of an array of discrete shims and a pattern of rings as part of a so-called "pole plate" is described in US-A-5 345 208. One arrangement having a recessed pole piece is known from US-A-2002/135450. The main field coil is contained within the recessed pole piece and the pole piece is located inside a cryostat. However, there remains a need to improve overall field homogeneity above and beyond the minor field adjustments possible using shimming alone. This is especially important in compact magnet designs and in those designs employing only a single superconducting magnet, i.e. asymmetric designs.

The present invention utilises an array of permanent magnets located close to the ferromagnetic member of a pole piece to improve field homogeneity in the imaging zone. Shims are employed in a separate layer to fine-tune the main field of individual machines prior to shipping or set-up.

Definition of the Invention

In general terms, according to the present invention, an MRI machine is provided in accordance with claim 1, which has been delimited against the disclosure of WO-A-2009/013478 (see the arrangement in Fig. 6 of this document). More specifically, the MRI machine comprises a yoke defining two opposing poles, and at only one of the two poles, a magnet comprising a superconducting coil and a pole piece assembly surrounded by the superconducting coil, wherein the pole piece assembly comprises a ferromagnetic member having a primary face for facing an imaging volume, a shim unit located between the primary face of the ferromagnetic member and the imaging volume and being separated from the primary face of the ferromagnetic member and a plurality of field-shaping permanent magnets situated between the shim unit and the primary face of the ferromagnetic member, wherein the imaging volume is defined as a spherical space having a diameter of from 50% to 66% of the distance between the poles along an axis of symmetry of the poles, the centre of the spherical volume being at the midpoint between the poles on said axis of symmetry or at a point +- 10 % from the midpoint along the axis of symmetry, wherein, when the superconducting magnet is operated with a circulating current, a main magnetic field is generated and wherein the field-shaping magnets are arranged such that the variation of field strength between any two points within the imaging volume is no more than 10 ppm; wherein the ferromagnetic member is provided with a projecting circumferential rim defining a recess comprising a side wall defined by the circumferential rim and a floor defined by the primary face of the ferromagnetic member; wherein the field-shaping magnets are supported above the primary face of the ferromagnetic member; and wherein at least some of the field-shaping permanent magnets are arranged in a tile pattern in a layer. One way of defining the invention in terms of the field-shaping magnets is based on an understanding of the different degree of effect and overall purpose of the field-shaping magnets, on the one hand, and shims, on the other hand.

Detailed Description of the Invention

The pole piece comprises a ferromagnetic member which concentrates the flux produced by the superconducting coil to generate the main field within the imaging volume. It has a primary face which is that external surface which in use, faces the subject to be imaged. Preferably that primary face is substantially planar or is profiled e.g. convex, concave or stepped. The ferromagnetic member is provided with a projecting circumferential rim defining a recess comprising a side wall defined by the circumferential rim and a floor defined by the primary face of the ferromagnetic member. Preferably, this circumferential rim has an inwardly sloping internal wall. Optionally, the field-shaping permanent magnets are of such a thickness that substantially all of them do not extend substantially above the height of the rim. In general, it is preferred that field-shaping permanent magnets cover at least 50%, more preferably at least 70%, most preferably at least 90% of the primary face of the ferromagnetic member. The field-shaping permanent magnets are supported above the primary face of the ferromagnetic member. Optionally, an intermediate layer of any suitable material may be situated between the magnets and the primary surface.

The shim unit may comprise a plurality of locations configured to receive individual shims in the form of permanent magnets, non-magnetised ferromagnetic members and combinations thereof, in order to fine-tune field homogeneity. It may be in the form of a shim plate having a plurality of recesses or shim holders to receive shims in chosen locations. The apparatus may be provided in combination with a set of shims for placing at least some in respective chosen one or more of the locations. The term 'shim unit' also extends to the situation wherein one or more of the shims are present in one or more of the locations. The shims are located in those positions selected so as to fine-tune field homogeneity within the imaging volume. Generally speaking, the shims are intended to be positionally adjustable whereas usually, the field shaping magnets are custom-made and integral with the magnet design. However, this is not an essential requirement.

It is preferred that the ratio of the spatial volume of field shaping permanent magnets to that of the shims is at least 10:1, more preferably at least 20:1, still more preferably at least 50:1, most preferably at least 100:1 but preferably no more than 1,000:1. Substantially all of the permanent magnet shims may have a maximum dimension of from 1mm to 20mm, preferably from 2mm to 15mm, more preferably from 4mm to 10mm and an axial thickness of from 0,1mm to 5mm, preferably from 0.5mm to 2mm. Regardless of size, substantially all of such shims may be circular disc or ring shaped.

Typically, the magnetic remanence of the field-shaping permanent magnets is from 0.3 Tesla to 1.5 Tesla, preferably from 1.2 Tesla to 1.5 Tesla and the shims comprise permanent magnets having a magnetic remanence of from 0.3 Tesla to 1.5 Tesla, preferably from 1.2 Tesla to 1.5 Tesla.

Optionally, the shims and/or shim locations are arranged in one or more layers. In some embodiments, there may be from 20 to 500, preferably from 100 to 400, more preferably from 200 to 300 field-shaping permanent magnets. There may be from 100 to 1,500, preferably from 300 to 1,200, more preferably from 400 to 800 shim locations in the shim unit.

In many preferred embodiments, the shim unit and field-shaping permanent magnets are spaced apart from each other. This provides possibility for one or more gradient coils to be located between the shim unit and the field-shaping permanent magnets.

The field-shaping permanent magnets may be arranged in one or more layers. There is a wide range of possibilities for the arrangement of the field-shaping permanent magnets. They may be uniformly or non-uniformly placed and uniformly or non-uniformly dimensioned, eg having different thicknesses and/or heights. For example, at least some of the field-shaping permanent magnets are arranged in concentric rings. Some of the field-shaping magnets are arranged in a tile pattern. In some arrangements, a first layer comprises field-shaping magnets arranged in concentric rings and a second layer comprises field-shaping magnets arranged in a tile pattern. The first layer may be situated between the primary surface of the ferromagnetic member and the second layer, or *vice versa.* As stated above, at least some field-shaping magnets have an irregular shape.

Substantially all of the field-shaping magnets may have a radial dimension of from 10mm to 75mm, preferably from 20mm to 60mm and an axial thickness of from 5mm to 90mm, preferably from 10mm to 75mm. The shape of the field-shaping magnets contributes to their influence upon the homogeneity of the main field and is tailored to the particular MRI machine where the hybrid magnet is employed. In many embodiments, substantially all of the field-shaping magnets are shaped as prisms widening in an outwardly radial direction. These prisms may have any shape, in particular, a regular shape, in cross-section, perpendicular to their axis of symmetry.

Typically, not all of the north-south orientations of individual field-shaping permanent magnets are oriented in the same direction as each other. In some embodiments, a first set of the field-shaping permanent magnets consists of individual magnets having north-south orientations aligned with an axis of symmetry of the pole piece assembly and a second set of the field-shaping permanent magnets consists of individual magnets having north-south orientations orthogonal to the axis of symmetry. The field-shaping permanent magnets having north-south orientations orthogonal to the axis of symmetry may have their respective north-south orientations oriented radially. The north-south orientations of the field-shaping permanent magnets may be arranged radially, extending along different radial directions. Those field-shaping permanent magnets having reverse radial north-south orientations may comprise sets of magnets respectively having a reverse north-south/south-north orientation relative to each other.

Those field-shaping permanent magnets having axial north-south orientations may comprise sets of magnets respectively having a reverse north-south/south-north orientations relative to each other.

In order to reduce the fringe field created by the main magnet, a shield coil may be situated on the reverse side of a magnet yoke arm relative to the side where the ferromagnetic member is situated. Like the ferromagnetic member, it may be in contact with the yoke arm or spaced apart therefrom. The shield coil is preferably of superconducting type, wound in the opposite sense to the associated main field coil but with fewer turns. The shield coil may also be provided with its own counterbalancing member, located on the other side of the shield coil from the yoke arm. Preferably the shield coil counterbalancing member comprises a ferromagnetic material.

The preferred design process of the size, shape, strength and positioning of the field-shaping permanent magnets is one in which the pole profiles and one or more layers of the field-shaping magnets are optimized in parallel - that is, during mathematical modelling, both are allowed to vary simultaneously . This method can achieve superior configurations that would not be possible if they were optimized sequentially.

Most generally the magnet has two opposing circular profiled poles with a common axis Z having a distribution of permanent field-shaping magnets on or spaced off the pole profile.

This method has been found to achieve a superior field homogeneity than that achieved if these parameters were optimized sequentially and a true integrated hybrid design can be achieved where both components are integral and complimentary.

The parameters determining the permanent magnet layers are the strength of magnetization which can be either axial or radial directions with positive or negative polarity.

For a magnet symmetric about the Z plane the parameter set applies to both poles and mirror symmetry about the plane Z=0 is maintained. For the most general asymmetric magnet, each pole is parameterised entirely independently of the other.

The primary objective in designing a magnet of sufficient quality for MRI is to achieve a good axially symmetric magnetic field. It is been generally found that the non-axially symmetric components of the field (hereinafter termed the transverse field), although certainly significant, tends to be of comparatively smaller magnitude than the axially symmetric inhomogeneity and it is therefore dealt with as a correction at a later stage in the design process. This is particularly true in the case of the asymmetric magnet where there is no base axial homogeneity whatsoever - even down to first order.

The principal parameters specifying a bare pole profile are its diameter, the axial position of its outer radial lip relative to isocentre and the shape of its profile. A practical allowable spatial envelope of variation is defined for each of these parameters.

The general approach to the magnetic design in this invention is a successive set of least squares optimizations based on accurate calibrations of sensitivities of parameters to their effect on the field. As the design evolves, different sets of variables are brought to bear on the problem as successive practical details of implementation are introduced into the magnetic model.

The method assumes access to both 2D and 3D finite element method (FEM) electromagnetic modelling and access to a least-squares optimizer subject to upper and lower boundary constraints and linear constraints. In addition custom designed software is required to handle the magnet data and interact with the external FEM and optimizer packages.

Detailed Magnet Optimization Procedure

1. The starting point for a new magnet design is pair of flat cylindrical pole pieces and an allowable envelope of variation for all pole parameters namely radius, axial (z) displacement and profile . The profile may be synthesised from the coefficients of an orthogonal set of basis functions such as Fourier series however a more practical method used in this invention uses the coefficients of a multiresolution set of basis functions such as linear or quadratic B-spline wavelets (see E.J.Stollnitz, T.D. DeRose, D.F. Salesin, Wavelets for Computer Graphics, Morgan Kaufmann Publishers , 1996) whose spatial frequency doubles for each successive level of detail and a set of coefficients can be assigned to the magnitude of each wavelet and for each level of resolution. Using such a basis set variables constituting the profile can be constrained to comply with the allowed pole envelope by applying linear constraints to the coefficients of the set. Also, a pole profile can naturally evolves first in low resolution with details appearing as successively higher resolution basis functions are gradually introduced.

2. In addition to the bare pole parameters, an annular set of uncommitted concentric rings of permanent magnets is arranged on the primary face of each pole with a fine radial period of the order of (say) 10 mm. A nominal thickness of the order of (say) 25 mm is given to this ring set. At this stage each ring in the set is permitted to have components of magnetization in both the axial or radial orientation. These variables are treated as being continuously variable and constrained to a magnitude obtainable from commercially available permanent magnets. They are also allowed to vary freely between full positive to full negative polarity.

3. Since the magnet involves the use of a non-linear ferromagnetic yoke and poles the magnetic field generated at any given point needs to be computer-modelled using the finite element method (FEM). Because this model is continually changing during the optimization for maximum efficiency the magnet model should be generated from a parameter file by means of a controlling computer program which automatically produces the scripts needed by the FEM package to build the model, solve it and acquire the results. The acquisition of this data is highly computationally intensive. However at least in the early stages a 2D axially symmetric approximation for the magnet can be used for the model as this can be solved much faster and with higher spatial resolution than a full 3D model. In the 2D approximation the asymmetric yoke is approximated by an equivalent axially-symmetrised pillbox yoke of similar cross section carrying the return flux between the poles.

4. At any given stage one monitors a representative sample of the magnetic field at m points in the imaging volume $B_1, B_2, ... B_j, ... B_m$, conveniently measured relative to the magnetic field $B_0$ at the isocentre of the magnet. Expressed in this way one can state that the objective for the achievement of a homogeneous magnet is equivalent to minimizing all the components of B. This field sample as a whole can represented as the m dimensional vector B. The sensitivity of the effect of variation of the physical variable dimensions of the pole and the magnetization of the rings is computed on these m points by changing each parameter in turn in the FEM model and re-solving and acquiring the perturbed field data. This operation and data collection is also acquired automatically by scripting. The data set of the sensitivity of all selected field points to variation of all the parameters is known as the sensitivity or Jacobian matrix as described in P.E.Gill, W.Murray, M.H.Wright, Practical Optimization, Academic Press, 1981. Suppose there are n variable parameters in the magnet design - whether spatial or magnetization, then the deviation of these variables from their existing values be represented as an n dimensional vector **x** whose members are $x_1, x_2, ... x_i, ... x_n$. Then the sensitivity matrix H has elements $H_{ij}$ given by :

$$H_{ij} = \partial B_j / \partial x_i$$

5. For small magnitudes of x one desires that after a change in x that the change in field will tend to cancel the existing deviation of field, thus the aim is to find the set of x which will tend to minimize the vector quantity **C = B - H x.** Formally, one seeks to minimize an objective function F(**x**) which is the least squares variation of magnetic field from isocentre which can conveniently be represented as the Euclidean norm of C , or

$$F(x) = \| \mathbf{C} \| = \| \mathbf{B} - \mathbf{Hx} \| = \sqrt{( C_1^2 + C_2^2 + ... C_m^2)}$$

The least-squares optimizer is run subject to upper and lower limits $u_i$ and $l_i$ on the change in each parameter $x_i$ which can reflect desired practical constraints but also to ensure the magnet does not change too much in one iteration such as to render the linear sensitivity calibration invalid. These limits can for each variable I can be expressed as

$$l_i < x_i < u_i.$$

Additionally, the least-squares optimizer can accommodate any desired number of linear constraints relative to one another where the $k^{th}$ linear constraint takes the following form

$$L_k < a_{k1} . x_1 + a_{k2} . x_2 + ... + a_{kn} . x_n < U_k .$$

Linear constrains are extremely useful for imposing constraints on the allowed envelope of the overall pole profile in terms of the pole shape variables, or at a later stage for example preventing the dimensions of rings varying such that they mechanically interfere with one another.

6. As the field iteratively improves after each optimization the model is updated and the sensitivity matrix is regularly refreshed. If, as the magnet optimizer proceeds, the pole profile evolves into the shape of a recessed profile, this can be taken advantage of by moving the plane of the permanent magnet ring array into that recess to make use of this vacated available space and then reoptimizing the magnet to account for that movement. By moving the rings into the recess the net unimpeded accessible gap between the poles of the magnet is thereby enhanced. It has been found in practice that a recessed profile tends to develop for poles which have an associated driving coil but that poles without a driving coil prefer to be nominally flat.

7. By optimizing the pole shape and permanent magnet rings in this way as simultaneous variables a hybrid design evolves that that requires both of these components to function successfully.

8. If a 2D computer FEM modelling approximation has been used up until this stage this finally needs to be replaced in further steps in this process by the full 3D FEM model to truly reflect the effects of the non-axisymmetric yoke design (for example a C or H configuration) on the actual field of the magnet and this will necessitate further corrections in the system design variables.

9. It is typically found in the evolutionary behaviour of the system, that neighbouring radial rings of the magnetized ring system will tend to clump together with similar orientations of magnetization. At this relatively late stage in the optimization, a manual choice can be made to aggregate these similar neighbouring rings into a smaller number of rings each with a larger radial area. Also, for reasons of practicality, rings can be assigned to be magnetized purely axially or purely radially depending on the dominant orientation that has naturally evolved - since these orientations are more easily manufactured. As axial space permits, the user may allow the some of these rings may be to vary with non-uniform axial thickness if the optimizer program indicates that this where a better solution may lie.

10. In making the transition from fine magnetized rings to a smaller number of thicker rings, the optimization variables for the rings are changed from variable magnetization to the individual inner and outer radii of the rings and if desired the axial thickness. As the optimization continues, further new linear constraints are imposed on the radial dimensions of the rings to ensure that the outer radius of one ring cannot interfere with the inner radius of the next ring out.

11. The rings may be further segmented into arc segments or the trapezoid approximation of an arc segment with a small azimuthal separation between neighbouring segments. These measures are needed to practically implement the design in real permanent magnet pieces while maintaining a high packing factor of permanent magnet material. A small reoptimization will be needed to account for this slight change in geometry and for the small amount magnetic material lost in this process. This configuration may be referred to as the axial or A layer.

12. With the axial optimization complete it is now necessary to modify the magnet to compensate for the transverse components of the field. Such means available include an angular tilt of the poles, a tilt of the floor of a recessed pole or most generally a non-axially symmetric set of features added to the pole profiles which can also be expressed as a set of multiresolution basis functions.

13. Should non-axially symmetric pole modifications prove inadequate, a thinner array of permanent magnet may be overlaid on the permanent magnet rings in an independently tiled pattern in either radial segments or squares. The strength of the effect of these tiles may be modulated by thickness or area and sign of magnetization in order to correct the transverse field using an independent constrained optimization designed to minimize the transverse components of field. We term the resulting correcting layer the transverse or T layer. This method has the advantage of making the each component of a given axial correcting ring from the same common part.

14. As an alternative embodiment to the independent transverse or T layer (13), the existing axial layer arrays can be modulated in two ways - the azimuthal spacing of the segments can be alternatively bunched or separated independently around each of the circular array, and or the axial thickness of the axial segments can be varied around the array. In this process priority can given to achieve solutions which minimize the number of distinct permanent magnet parts needed for the whole assembly. In general a combination of measures outlined in steps 11 to 13 may be optimized in parallel to compensate for transverse magnetic field compensation.

15. Since in practice axial and transverse correction mechanisms will not be perfectly orthogonal in effect the final optimization must take into account all components of the field both axial and transverse and repeatedly reoptimize the complete field in groups of parameters by small amounts of the whole system to fine tune the field and produce a custom designed superconducting - permanent hybrid magnet.

So in summary, a method of designing a hybrid magnet may comprise the steps:

(i) choosing an allowable envelope of variation for radial and axial variation for the ferromagnetic member of the pole piece;
(ii) assuming a predetermined annular set of field shaping permanent magnets arranged in concentric rings arranged on or above the primary face of the ferromagnetic member;
(iii) performing a two dimensional approximation of the ferromagnet field generated within the imaging volume, preferably using the finite element method;
(iv) determining the field intensity at a finite number of points within the imaging volume;
(v) computing the sensitivity of the field intensity at the finite number of points, to fundamental parameters consisting of the size, shape, orientation and degree of magnetisation of the field shaping permanent magnets;
(vi) optimizing the fundamental parameters to achieve a predetermined degree of field homogeneity within the imaging volume; and
(vii) repeating steps (iii) - (vi) using three dimensional representation of the field shaping permanent magnets.

As indicated above, the main field magnet of an MRI machine has one hybrid magnet located at only one pole and a pole piece of another design, be it passive or having its own energising coil at the other pole. In most designs, the pole pieces are mounted on a yoke, substantially facing each other. Therefore, preferably, the yoke is generally H-shaped or generally C-shaped although to enable access of a subject in a range of orientations, generally C-shaped is much preferred.

The ferromagnetic member of the hybrid magnet may optionally be provided with a balancing member to counterbalance, preferably to substantially totally counterbalance, the attractive force between the coil and the yoke, as disclosed in WO-A-2009/013478. This balancing member may be spaced apart from, or integral with, the ferromagnetic member. Typically, the balancing member may be annular.

Each pole piece may be constructed as a composite, for example, comprising two or more constituent members made from different materials, e.g. two or more generally annular shaped pieces which may be joined by any suitable means such as bolting. One or more of these individual members may constitute a balancing member as described in WO-A-2009/013478 and may optionally be formed of material(s) having a higher magnetic permeability and/or higher saturation than the yoke.

The superconducting coil of the hybrid magnet may be provided with a suitable cooling means. Particularly preferred are coils made from one or more high temperature superconducting materials. By 'high temperature superconducting material' is meant a material which demonstrates superconductivity at a temperature above 20°K. Alternatively, 'high temperature superconducting material' may also be interpreted to mean a material with a superconducting working temperature operating as a magnet of above 10°K. That is because for many of these materials, the onset of superconductivity in the characteristic curve of the superconductor is not very sharp. Therefore, lower temperatures than the highest at which superconductivity is first demonstrated are preferred for better performance. A particularly preferred high temperature superconductor is magnesium diboride ($MgB_2$) or $MgB_2$ doped with another suitable material such as silicon carbide, hosted in a matrix of copper. Other suitable high temperature superconductors include niobium nitride, niobium carbide, niobium boride and molybdenum diboride, although these materials require lower temperatures than $MgB_2$. Yet other high temperatures superconductors which could be used include bismuth strontium calcium copper oxide (BSCCO) and yttrium barium copper oxide (YBCO) which have a higher critical temperature but are generally less suited to high current density and long wire applications, as well as being more expensive.

In use, the superconducting coil may operate in persistent mode or may be continuously energised by an attached power supply.

With a generally C-shaped yoke, the pole pieces (at least one of which would be part of a hybrid magnet according to the present invention) would normally be fixed to a respective arm member which is joined by a support member and can share a common cryo-cooling system.

Brief Description of the Drawings

The present invention will now be explained by way of the following description of preferred embodiments and with reference to the accompanying drawings, in which:-

Figure 1 shows a cross-section through the pole piece axis of symmetry of a first embodiment of a hybrid magnet structure according to the present invention, as used in an MRI machine;

Figure 2 shows a plan view of the shim plate depicted in Figure 1;

Figure 3 shows the arrangement of the transverse field shaping permanent magnet layer of the structure shown in Figure 1;

Figure 4 shows the arrangement of the axial field shaping permanent magnet layer of the structure shown in Figure 1;

Figure 5 shows a cross-section through a second embodiment of a pole piece assembly according to the present invention;

Figure 6 shows a cross-section through a modified embodiment in which a shield coil is provided; and

Figure 7 shows a cross-section through another modified embodiment in which the field shaping magnets are arranged in a single layer.

Description of Preferred Embodiments

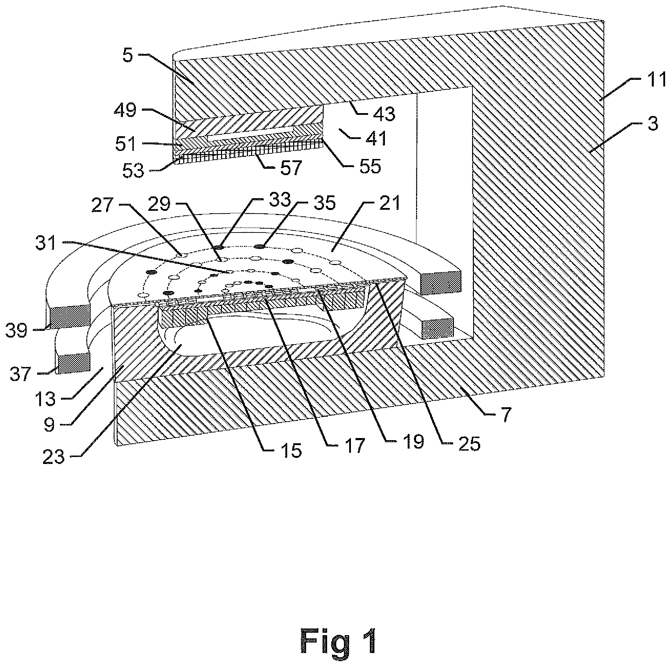

Figure 1 of the drawings shows a cross-section through an example of an MRI machine of the invention which comprises the structure 1 comprises a yoke 3 comprising an upper arm 5 and a lower arm 7. The lower arm 7 supports a ferromagnetic member 9. The upper arm 5 and the lower arm 7 of the yoke are connected by a spine 11. The ferromagnetic member is part of a pole piece assembly 13 which comprises the ferromagnetic member 9 and then: an axial field shaping permanent magnet layer 15 (for axial field shaping), a transverse field shaping permanent magnetic layer 17 (for transverse field shaping), a gradient coil arrangement 19 and a shim plate 21, stacked in that order from the bottom up; inside a recess 23 formed in the ferromagnetic member 9, with the shim plate 21 uppermost and the axial field shaping permanent magnetic layer 15 lowermost. The upper surface 25 of the ferromagnetic member 9 faces towards the subject to be imaged, when in use. It is covered by the shim plate 21.

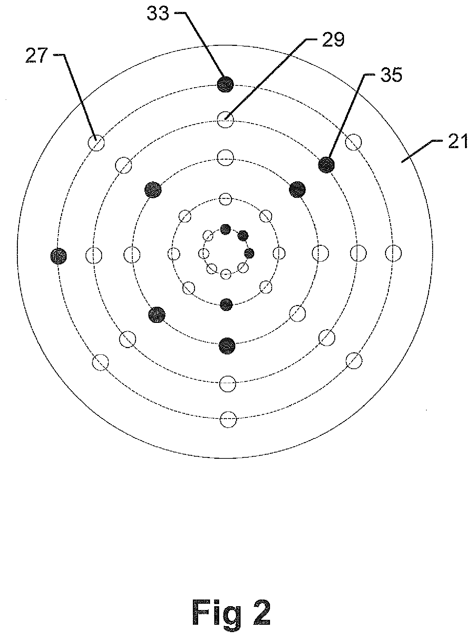

The shim plate 21, contains a plurality of recesses 27, 29, 31 etc, in this case arranged in concentric circles, in which individual shim magnets 33, 35 etc may be located. The location of these shims is determined as hereinbefore described as is the size, shape and orientation of both of the layers 15, 17. A plan view of the shim plate with magnet locations and magnets is shown in Figure 2.

The ferromagnetic member of the pole piece assembly 13 is surrounded by a superconducting magnetic coil 37. Above that superconducting coil, parallel therewith but spaced apart therefrom, is a counterbalancing member 39 of the kind described in WO-A-2009/013478.

On the other side of the imaging volume where the subject to be imaged would be positioned in use, is situated a complimentary pole piece assembly 41 which is smaller both in diameter and height, relative to the lower pole piece assembly 13. It is supported on the underside 43 of the upper arm 5. This pole piece assembly comprises in layers, in the following order extending from the underside 43 of the upper arm 5, towards the imaging region and the other pole piece assembly 13, a ferromagnetic member 49, an axial field shaping permanent magnet layer 51, a transverse field shaping permanent magnet layer 53, a gradient coil arrangement 55 and a shim plate with shim magnets 57. The structure of the upper pole piece assembly is otherwise analogous to the lower pole piece assembly 13 but lacks the superconducting coil and counterbalancing member.

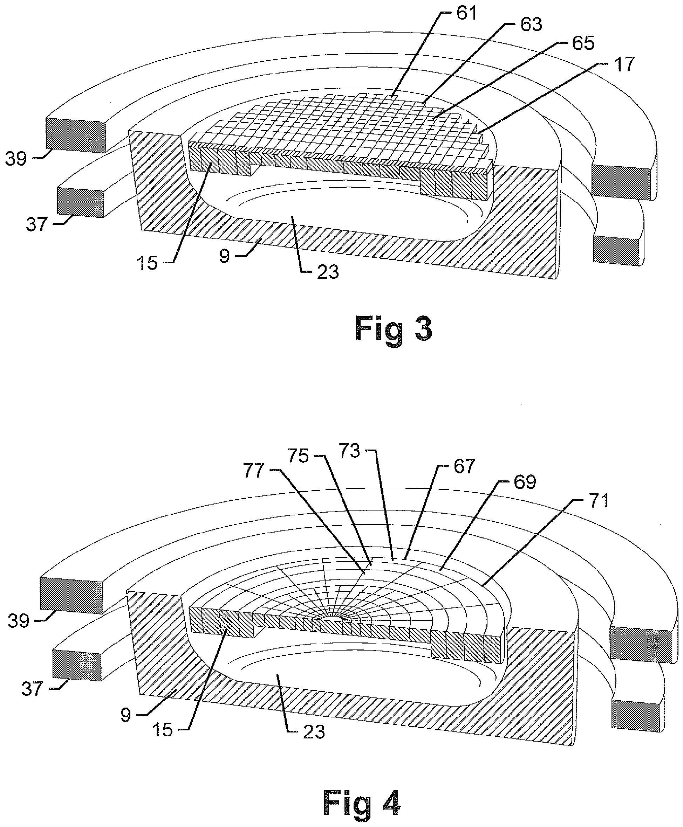

Further details of the transverse field shaping permanent magnetic layer 17 are shown in Figure 3. It can be seen that this layer comprises a plurality of permanent magnets 61, 63, 65 etc arranged in a tile fashion.

The axial field shaping permanent magnet layer 15 is situated underneath the layer of the transverse field shaping permanent magnets 17, as shown in more detail in Figure 4. The axial field shaping magnets are arranged in radial segments 67, 69, 71 etc. Each such segment comprises arcuate permanent magnets 73, 75, 77 etc so that the arcuate magnets are arranged in concentric rings. It can be seen that not all of these arcuate magnets are of the same size or shape.

In Figure 3, the North-South axis of each permanent magnet is oriented axially N-S or S-N. The North-South axis of the arcuate magnet shown in Figure 4 are independently arranged axially or radially, either N-S or S-N.

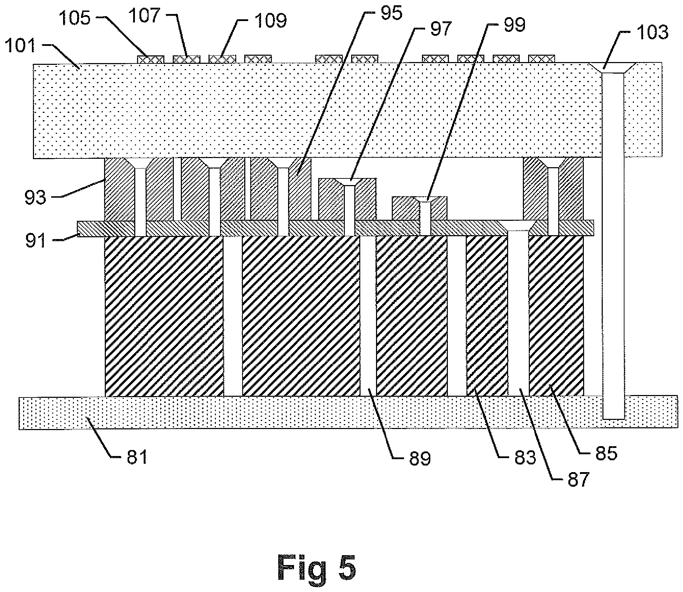

The layer of transverse field shaping permanent magnets 17 is situated directly under the gradient coil arrangement 19 whilst the layer 15 of the axial field shaping permanent magnets is arranged directly beneath the layer of the transverse magnets 17. Both are situated inside the recess 23. However, Figure 5 shows an alternative form of construction in which the field shaping permanent magnets are bolted to a substrate anchor which rests in the bottom of the recess of the ferromagnetic member 9. This substrate anchor 81 supports axial field shaping permanent magnets 83, 85 etc which are attached thereto by bolts 87 etc which are located in holes 89 etc through the layer of the transverse field shaping permanent magnets. Above the transverse field shaping permanent magnets is situated a plate 91 for supporting the transverse field shaping permanent magnets. This is fixed to the substrate anchor by means of the bolts 87 etc passing therethrough. A plurality of the transverse field shaping permanent magnets 93, 95 etc are fixed to the plate 91 by means of bolts 97, 99 etc. It can be seen that the transverse field shaping permanent magnets are not all of the same height. Any of the bolting arrangements may be substituted by gluing, eg using an epoxy adhesive.

A gradient coil stack 101 is located directly above the layer of transverse field shaping permanent magnets and is fixed to the substrate anchor by means of bolts 103 etc.

The fine tuning shims (shim magnets) 105, 107, 109 etc are located immediately above the gradient coil stack and may be held in a shim plate as in the previous embodiment.

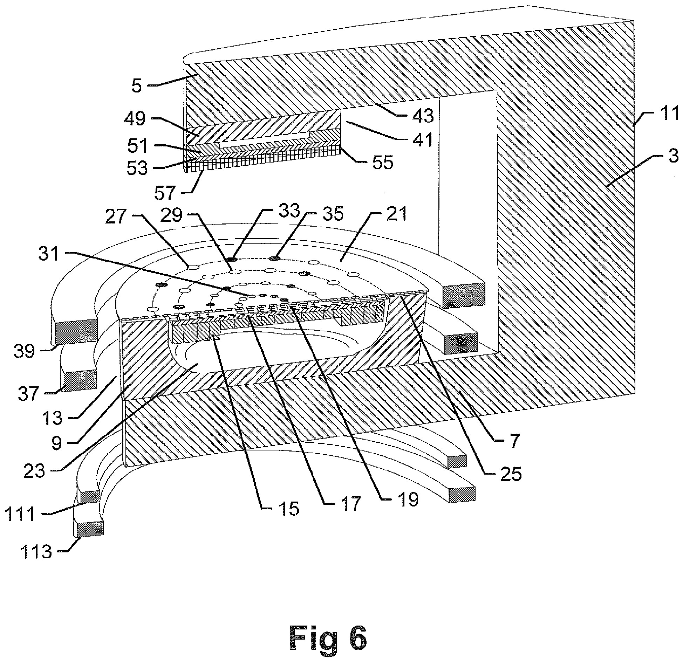

Figure 6 shows a modification of the embodiment of Figure 1. Like reference numerals denote the same integers as in the latter embodiment. However, in this modification, shield coil 111 is provided, lying below the lower member 7 but substantially coaxial and parallel with the primary coil 37. This shield coil also is provided with its own balancing ring 113. This is substantially coaxial with the shield coil 111 and parallel therewith but is situated on the opposite side of the shield coil, relative to the lower member 7. This counterbalancing ring may be made of any material which may be used for the primary counterbalancing member 39, as described in WO-A-2009/013487. Preferably this is ferromagnetic material.

The shield coil 111 is also superconducting but has fewer ampere turns than primary coil 37 and the current is arranged to flow in the opposite sense to that in the primary coil 37. Its purpose is to reduce at source the fringe field created by the magnet while only marginally reducing the main field. The shield coil is run in series with the main coil 37 and shares the same cryostat. A magnet with a smaller fringe field is easier to site and reduces any shielding requirements on site.

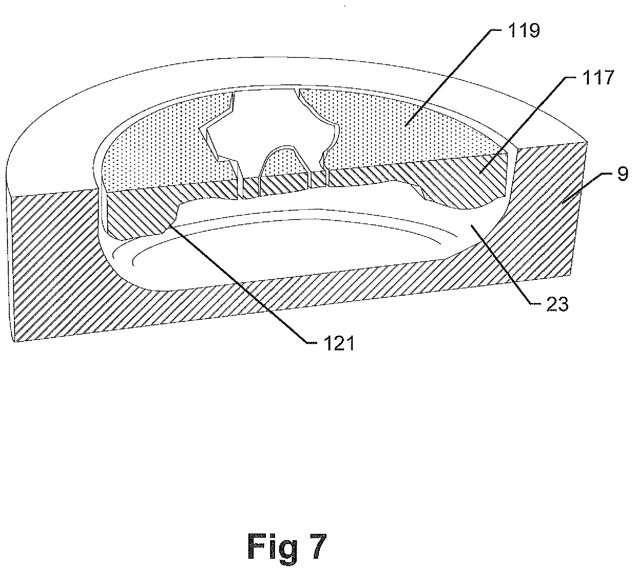

Figure 7 shows another possible modification of the field shaping magnets within the recess 23 of the ferromagnetic member 9. In this case, a layer 117 of permanent field shaping magnets has a substantially planar upper surface 119 and an irregularly profiled lower surface 121 by virtue of being formed of a single layer of permanent magnet material which comprises a plurality of permanent magnet pieces (not shown) shaped in plan outline, cross-section thickness and having varying sized gaps therebetween. The number of permanent magnet pieces and their size, dimension, orientation and spacings are determined as hereinbefore described to optimize field homogeneity within the imaging volume. As in the other embodiments, shims may be used for fine tuning of the field.

In the light of the described embodiments, modifications of those embodiments, as well as other embodiments, for example as defined by any one or more of the appended claims, will now become apparent to persons skilled in the art.

## Claims

1. An MRI machine comprising a yoke (3) defining two opposing poles (5,7) and, at only one of the two poles (7), a magnet comprising a superconducting coil (37) and a pole piece assembly (13) surrounded by the superconducting coil (37), wherein the pole piece assembly (13) comprises a ferromagnetic member (9) having a primary face for facing an imaging volume, **characterized in that**
the MRI machine further contains a shim unit (21) located between the primary face of the ferromagnetic member (9) and the imaging volume, which shim unit (21) is separated from the primary face of the ferromagnetic member (9), and a plurality of field-shaping permanent magnets (15, 17) situated between the shim unit (21) and the primary face of the ferromagnetic member (9), wherein the imaging volume is defined as a spherical space having a diameter of from 50% to 66% of the distance between the poles along an axis of symmetry of the poles, the centre of the spherical volume being at the midpoint between the poles on said axis of symmetry or at a point +- 10% from the midpoint along the axis of symmetry, wherein, when the superconducting magnet is operated with a circulating current a main magnetic field if generated and wherein the field-shaping magnets are arranged such that the variation of field strength between any two points within the imaging volume is no more than 10ppm;
the ferromagnetic member (9) is provided with a projecting circumferential rim defining a recess (23) comprising a side wall defined by the circumferential rim and a floor defined by the primary face of the ferromagnetic member (9);
the field-shaping permanent magnets (15, 17) are supported above the primary face of the ferromagnetic member (9); and
at least some of the field-shaping permanent magnets (15, 17) are arranged in a tile pattern in a layer.

2. An MRI machine according to claim 1, wherein the primary face of the ferromagnetic member (9) is substantially planar or is profiled.

3. An MRI machine according to claim 1 or 2, wherein the circumferential rim has an inwardly sloping internal wall.

4. An MRI machine according to any preceding claim, wherein the field-shaping permanent magnets (15, 17) do not extend above the height of the rim.

5. An MRI machine according to any preceding claim, wherein the shim unit (21) and field-shaping permanent magnets (15, 17) are spaced apart from each other.

6. An MRI machine according to claim 5, wherein one or more gradient coils (19) are located between the shim unit (21) and the field-shaping permanent magnets (15, 17).

7. An MRI machine according to any preceding claim, wherein a first layer (17) comprises field-shaping magnets (67, 69, 71, 73, 75, 27) arranged in concentric rings and a second layer (15) comprises the field-shaping magnets (15, 17) arranged in a tile pattern.

8. An MRI machine according to claim 7, wherein the first layer (17) is situated between the primary surface of the ferromagnetic member and the second layer (15).

9. An MRI machine according to any preceding claim wherein the north-south orientations of individual field-shaping permanent magnets are not all oriented in the same direction as each other.

10. An MRI machine according to claim 9, wherein a first set of the field-shaping permanent magnets consists of individual magnets having north-south orientations aligned with the axis of symmetry and a second set of the field-shaping permanent magnets consists of individual magnets having north-south orientations orthogonal to the axis of symmetry.

11. An MRI machine according to claim 9 or claim 10, wherein the field-shaping permanent magnets having north-south orientations orthogonal to the axis of symmetry have their respective north-south orientations oriented radially.

12. An MRI machine according to any preceding claim, wherein the pole (5) without the superconducting coil comprises a pole piece assembly (41) that comprises a ferromagnetic member (49) having a primary face for facing an imaging volume, a shim unit (57) being separated from the primary face of the ferromagnetic member (49) and a plurality of field-shaping permanent magnets situated between the shim unit (57) and the primary face of the ferromagnetic member (49).

**Patentansprüche**

1. MRT-Maschine, umfassend ein Joch (3), das zwei entgegengesetzte Pole (5, 7) definiert, und nur an einem der Pole (7) einen Magneten, der eine supraleitende Spule (37) und eine von der supraleitenden Spule (37) umgebene Polschuhbaugruppe (13) umfasst, worin die Polschuhbaugruppe (13) ein ferromagnetisches Teil (9) mit einer Primärfläche zum Richten auf ein Abbildungsvolumen umfasst,
   **dadurch gekennzeichnet, dass** die MRT-Maschine ferner enthält:

   eine Ausgleichsstückeinheit (21), die zwischen der Primärfläche des ferromagnetischen Teils (9) und dem Abbildungsvolumen angeordnet ist, wobei diese Ausgleichsstückeinheit (21) von der Primärfläche des ferromagnetischen Teils (9) getrennt ist, und
   eine Vielzahl von feldformenden Permanentmagneten (15, 17), die sich zwischen der Ausgleichsstückeinheit (21) und der Primärfläche des ferromagnetischen Teils (9) befinden, worin das Abbildungsvolumen als ein kugelförmiger Raum mit einem Durchmesser von 50% bis 66% des Abstandes zwischen den Polen entlang einer Symmetrieachse der Pole definiert ist, wobei das Zentrum des kugelförmigen Volumens im Mittelpunkt zwischen den Polen auf der Symmetrieachse oder an einem Punkt ±10% vom Mittelpunkt entlang der Symmetrieachse liegt, worin ein Hauptmagnetfeld erzeugt wird, wenn der supraleitende Magnet mit einem zirkulierenden Strom betrieben wird, und worin die feldformenden Magnete so angeordnet sind, dass die Abweichung der Feldstärke zwischen zwei beliebigen Punkten innerhalb des Abbildungsvolumens nicht größer als 10 ppm ist; wobei das ferromagnetische Teil (9) mit einem vorstehenden umlaufenden Kranz versehen ist, der eine Vertiefung (23) definiert, die eine durch den umlaufenden Kranz definierte Seitenwand und einen durch die Primärfläche des ferromagnetischen Teils (9) definierten Boden umfasst; wobei die feldformenden Permanentmagnete (15, 17) oberhalb der Primärfläche des ferromagnetischen Teils (9) gelagert sind; und mindestens einige der feldformenden Permanentmagnete (15, 17) in einem Kachelmuster in einer Schicht angeordnet sind.

2. MRT-Maschine nach Anspruch 1, worin die Primärfläche des ferromagnetischen Teils (9) im Wesentlichen eben oder profiliert ist.

3. MRT-Maschine nach Anspruch 1 oder 2, worin der umlaufende Kranz eine nach innen geneigte innere Wand hat.

4. MRT-Maschine nach einem der vorhergehenden Ansprüche, worin die feldformenden Permanentmagnete (15, 17) sich nicht über die Höhe des Kranzes hinaus erstrecken.

5. MRT-Maschine nach einem der vorhergehenden Ansprüche, worin die Ausgleichsstückeinheit (21) und die feldformenden Permanentmagnete (15, 17) voneinander beabstandet sind.

6. MRT-Maschine nach Anspruch 5, worin eine oder mehrere Gradientenspulen (19) zwischen der Ausgleichsstückeinheit (21) und den feldformenden Permanentmagneten (15, 17) angeordnet sind.

7. MRT-Maschine nach einem der vorhergehenden Ansprüche, worin eine erste Schicht (17) feldformende Magnete (67, 69, 71, 73, 75, 27) umfasst, die in konzentrischen Ringen angeordnet sind, und eine zweite Schicht (15) diejenigen feldformenden Magnete (15, 17) umfasst, die in einem Kachelmuster angeordnet sind.

8. MRT-Maschine nach Anspruch 7, worin die erste Schicht (17) sich zwischen der Primärfläche des ferromagnetischen Teils und der zweiten Schicht (15) befindet.

9. MRT-Maschine nach einem der vorhergehenden Ansprüche, worin die Nord-Süd-Orientierungen einzelner feldformender Permanentmagnete nicht alle in die gleiche Richtung ausgerichtet sind.

10. MRT-Maschine nach Anspruch 9, worin eine erste Menge der feldformenden Permanentmagnete aus einzelnen Magneten besteht, die an der Symmetrieachse ausgerichtete Nord-Süd-Orientierungen haben, und eine zweite Menge der feldformenden Permanentmagnete aus einzelnen Magneten besteht, die zur Symmetrieachse orthogonale Nord-Süd-Orientierungen haben.

11. MRT-Maschine nach Anspruch 9 oder 10, worin die feldformenden Permanentmagnete mit zur Symmetrieachse orthogonalen Nord-Süd-Orientierungen ihre jeweiligen Nord-Süd-Orientierungen radial ausgerichtet haben.

12. MRT-Maschine nach einem der vorhergehenden Ansprüche, worin der Pol (5) ohne die supraleitende Spule umfasst: eine Polschuhbaugruppe (41), die ein ferromagnetisches Teil (49) mit einer Primärfläche zum Richten auf ein Abbildungsvolumen umfasst, eine Ausgleichsstückeinheit (57), die von der Primärfläche des ferromagnetischen Teils (49) getrennt ist, und eine Vielzahl von feldformenden Permanentmagneten, die sich zwischen der Ausgleichsstückeinheit (57) und der Primärfläche des ferromagnetischen Teils (49) befinden.

## Revendications

1. Machine IRM comprenant une culasse (3) qui définit deux pôles opposés (5, 7) et, au niveau de seulement l'un des deux pôles (7), un aimant qui comprend une bobine supraconductrice (37) et un ensemble de pièces polaires (13) qui est entouré par la bobine supraconductrice (37), dans laquelle l'ensemble de pièces polaires (13) comprend un élément ferromagnétique (9) qui comporte une face primaire pour faire face à un volume d'imagerie, **caractérisée en ce que** la machine IRM contient en outre :

   une unité de rondelle (21) qui est située entre la face primaire de l'élément ferromagnétique (9) et le volume d'imagerie, laquelle unité de rondelle (21) est séparée de la face primaire de l'élément ferromagnétique (9) ; et une pluralité d'aimants permanents de mise en forme de champ (15, 17) qui sont situés entre l'unité de rondelle (21) et la face primaire de l'élément ferromagnétique (9), dans laquelle le volume d'imagerie est défini en tant qu'espace sphérique qui présente un diamètre qui va de 50 % à 66 % de la distance entre les pôles suivant un axe de symétrie des pôles, le centre du volume sphérique étant au niveau du point médian entre les pôles sur ledit axe de symétrie ou au niveau d'un point situé à $\pm$ 10 % du point médian suivant l'axe de symétrie, dans laquelle, lorsque l'aimant supraconducteur est actionné avec un courant qui circule, un champ magnétique principal est généré et dans laquelle les aimants de mise en forme de champ sont agencés de telle sorte que la variation de l'intensité du champ entre deux points quelconques à l'intérieur du volume d'imagerie ne soit pas supérieure à 10 ppm ;
   l'élément ferromagnétique (9) est muni d'un bord circonférentiel faisant saillie qui définit un évidement (23) qui comprend une paroi latérale qui est définie par le bord circonférentiel et un fond qui est défini par la face primaire de l'élément ferromagnétique (9) ;
   les aimants permanents de mise en forme de champ (15, 17) sont supportés au-dessus de la face primaire de l'élément ferromagnétique (9) ; et
   au moins certains des aimants permanents de mise en forme de champ (15, 17) sont agencés selon un motif de pavés dans une couche.

2. Machine IRM selon la revendication 1, dans laquelle la face primaire de l'élément ferromagnétique (9) est sensiblement plane ou est profilée.

**3.** Machine IRM selon la revendication 1 ou 2, dans laquelle le bord circonférentiel comporte une paroi interne en pente vers l'intérieur.

**4.** Machine IRM selon l'une quelconque des revendications qui précèdent, dans laquelle les aimants permanents de mise en forme de champ (15, 17) ne s'étendent pas au-dessus de la hauteur du bord.

**5.** Machine IRM selon l'une quelconque des revendications qui précèdent, dans laquelle l'unité de rondelle (21) et les aimants permanents de mise en forme de champ (15, 17) sont espacés les uns des autres.

**6.** Machine IRM selon la revendication 5, dans laquelle une ou plusieurs bobine(s) de gradient (19) est/sont située(s) entre l'unité de rondelle (21) et les aimants permanents de mise en forme de champ (15, 17).

**7.** Machine IRM selon l'une quelconque des revendications qui précèdent, dans laquelle une première couche (17) comprend des aimants de mise en forme de champ (67, 69, 71, 73, 75, 27) qui sont agencés selon des anneaux concentriques, et une seconde couche (15) comprend les aimants de mise en forme de champ (15, 17) qui sont agencés selon un motif de pavés.

**8.** Machine IRM selon la revendication 7, dans laquelle la première couche (17) est située entre la surface primaire de l'élément ferromagnétique et la seconde couche (15).

**9.** Machine IRM selon l'une quelconque des revendications qui précèdent, dans laquelle les orientations Nord-Sud d'aimants permanents de mise en forme de champ individuels ne sont pas toutes orientées dans la même direction les unes que les autres.

**10.** Machine IRM selon la revendication 9, dans laquelle un premier jeu des aimants permanents de mise en forme de champ est constitué par des aimants individuels qui présentent des orientations Nord-Sud qui sont alignées avec l'axe de symétrie, et un second jeu des aimants permanents de mise en forme de champ est constitué par des aimants individuels qui présentent des orientations Nord-Sud qui sont orthogonales à l'axe de symétrie.

**11.** Machine IRM selon la revendication 9 ou la revendication 10, dans laquelle les aimants permanents de mise en forme de champ qui présentent des orientations Nord-Sud qui sont orthogonales à l'axe de symétrie ont leurs orientations Nord-Sud respectives qui sont orientées radialement.

**12.** Machine IRM selon l'une quelconque des revendications qui précèdent, dans laquelle le pôle (5) sans la bobine supraconductrice comprend un ensemble de pièces polaires (41) qui comprend un élément ferromagnétique (49) qui comporte une face primaire pour faire face à un volume d'imagerie, une unité de rondelle (57) qui est séparée de la face primaire de l'élément ferromagnétique (49) et une pluralité d'aimants permanents de mise en forme de champ qui sont situés entre l'unité de rondelle (57) et la face primaire de l'élément ferromagnétique (49).

**Fig 1**

Fig 2

**Fig 3**

**Fig 4**

Fig 5

**Fig 6**

**Fig 7**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009013478 A
- US 5431165 A
- US 5194810 A
- US 6335670 A
- US 5345208 A
- US 2002135450 A
- WO 2009013487 A

**Non-patent literature cited in the description**

- **E.J.STOLLNITZ ; T.D. DEROSE ; D.F. SALESIN.** Wavelets for Computer Graphics. Morgan Kaufmann Publishers, 1996
- **P.E.GILL ; W.MURRAY ; M.H.WRIGHT.** Practical Optimization. Academic Press, 1981